(19) Europäisches Patentamt

European Patent Office

Office européen des brevets

(11) **EP 0 887 931 A1**

(12) **EUROPEAN PATENT APPLICATION**

(43) Date of publication:
30.12.1998 Bulletin 1998/53

(51) Int. Cl.⁶: **H03K 17/06**

(21) Application number: 97830296.6

(22) Date of filing: 24.06.1997

(84) Designated Contracting States:
AT BE CH DE DK ES FI FR GB GR IE IT LI LU MC NL PT SE

(71) Applicant:
STMicroelectronics S.r.l.
20041 Agrate Brianza MI (IT)

(72) Inventors:
• Tarantola, Mario
20010 Bareggio (IT)
• Cantone, Giuseppe
96100 Siracusa (IT)
• Genova, Angelo
93010 Delia (IT)
• Gariboldi, Roberto
20084 Lacchiarella (IT)

(74) Representative:
Pellegri, Alberto et al
c/o Società Italiana Brevetti S.p.A.
Via Puccini, 7
21100 Varese (IT)

(54) **Protection circuit for controlling the gate voltage of a high voltage LDMOS transistor**

(57) A circuit for charging a capacitance (C) by means of an LDMOS integrated transistor (LD) functioning as a source follower stage and controlled, in a manner to emulate a high voltage charging diode of the capacitance via a bootstrap (Cp) capacitor charged by a diode (D1) connected to the supply node (Vs) of the circuit, by an (IO1) inverter driven by a logic control circuit in function of a first Low Gate Drive Signal and of a second logic signal (UVLOb) which is active during a phase where the supply voltage (Vs) is lower than the minimum switch-on voltage of the integrated circuit, comprises further a second inverter (M1, M2), functionally referred to the charging node of said bootstrap (Cp) capacitor and to the voltage of the output node (A) of said inverter (IO1) and having an input coupled to said second logic signal (UVLOb) and an output coupled to the gate node of said LDMOS transistor (LD), for preventing accidental undue switch-on of the LDMOS transistor.

Fig. 2

EP 0 887 931 A1

## Description

The present invention relates to integrated circuits and in particular to driving circuits of power stages. Particularly, the invention refers to a bootstrap system or the like wherein a capacitor is charged by means of an LDMOS integrated transistor emulating a high voltage diode.

In integrated circuits that comprise output stages destined to drive discrete power devices or themselves integrated on the same chip containing the control circuitry, it is recurrent the use of a bootstrap capacitor to ensure a correct powering of the driving stage. In these systems, it is essential that the bootstrap capacitance is charged in very short periods of time and this is usually attained through a diode emulator LDMOS transistor used to rapidly charge the bootstrap capacitance.

In the case of a driving circuit for a so-called High Side Driver (HSD) of a half-bridge output stage, the LDMOS should be capable of charging the bootstrap capacitance when the HSD is referred to low voltage (that is when its output is low), while the LDMOS should emulate a high impedance when the HSD is referred to high voltage (that is, when its output is high.). These functioning conditions must be also ensured during the HSD switching phase from high to low voltage or vice versa, despite of the possible current injections of deriving from charging and discharging processes of the capacitances associated to the LDMOS integrated structure that must sustain the high voltage supply of the power device.

The publication WO 94/27370 discloses a half-bridge circuit comprising a driving module of the lower device and a driving floating module of the higher power device, in which the driving module of the higher transistor is realized in an isolated well region and a properly controlled LDMOS transistor emulates a high voltage charging diode of a bootstrap capacitor.

In these cases it is necessary to control the effects of the parasite bipolar junction transistors associated to an LDMOS integrated structure.

The document EP-A-0743752, points out and describes certain conditions that originate problems tied to the switch-on of parasite transistors of the LDMOS integrated structure, describing also different circuit layouts capable to avert current consumptions caused by the switch-on of parasite transistors of the LDMOS integrated structure and to avoid the occurrence of conditions that may cause the destruction of the integrated device itself.

The above cited European patent application EP-A-0743752, is herein incorporated by way of direct reference. Figure 1 highlights the protecting circuit device described in said previous European patent application.

According to the solution described in said previous European patent application, there exists a functioning phase of the integrated circuit, referred to as UVLO, when the voltage supply Vs is less than the minimum switch-on voltage of the entire integrated device including also the LDMOS, during which, being SW1 and SW2 both open, the potential of the VB body node of the LDMOS structure is kept at the circuit ground potential.

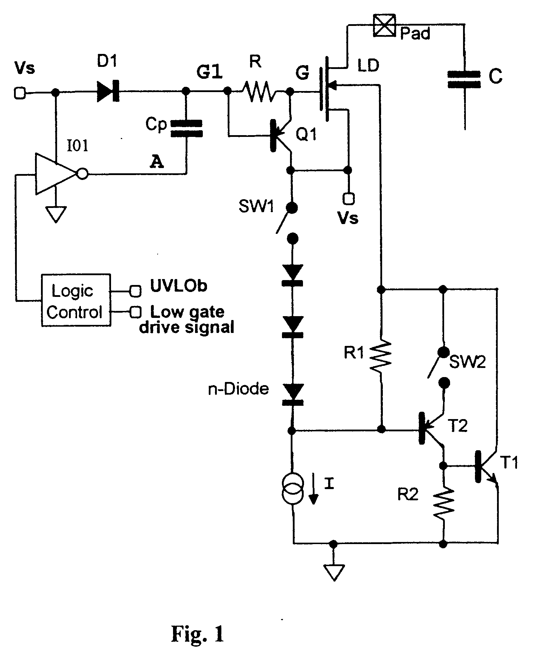

Figure 1 shows that the LDMOS transistor is controlled through a bootstrap capacitor Cp charged by a diode D1 connected to the circuit Vs supply node, by an inverter IO1 driven by a Logic Control circuit in function of a Low Gate Drive Signal and a second logic drive signal (UVLOb), which is active during a phase wherein the Vs supply voltage is lower than the minimum switch-on voltage of the integrated device.

The protecting circuit as described in said preceding European Patent application herein reproduced in figure 1, while usually effective to prevent spurious switch-on, it has the disadvantage of requiring, in order to carry out such function, that the current be such that the fall on the R resistance is sufficient to switch-on the transistor Q1 and this condition may not occur in some cases, for example, in quasi-static conditions or in the presence of leakage currents.

In fact, when the LDMOS transistor (LD) is OFF (node A linked to ground potential via the IO1 inverter), its gate (G) represents a high impedance node. This constitutes a particularly critical condition from the point of view of leakage currents entering the G node, or of possible charge injections on the same G node through the capacitive coupling between the gate-drain capacitance of the LDMOS transistor and the bootstrap capacitance Cp, caused by steep fronts during high voltage switching.

These charges that may be accidentally injected on the G node tend to increase the potential which, not being limited, could theoretically reach a voltage equal to Vs+Vz, where Vz is the breakdown voltage of the D1 diode that charges the bootstrap capacitance Cp.

In any case, it is sufficient that the Vgs voltage reaches a level of a few Volts to cause an undesired switch-on of the LDMOS (LD) transistor, despite the existence of a switch-off logic signal on the A output node of the control inverter IO1.

A similarly undue switch-on of the LDMOS transistor my take place in the switch-off phase, if the Vs voltage is taken to ground in a time span that would not allow the gate potential of the LDMOS transistor to follow the source voltage. The effect of an anomalous switch-on is a reverse current that may damage the integrated transistor LDMOS or in any case discharge the C capacitance charged by it.

It should now be evident the need or opportunity to implement a secure control of the gate voltage of the LDMOS transistor thus to avert occurrences of undesired switch-on.

The present invention provides an effective answer to this need by using of a damp circuit of the LDMOS gate node potential, conditioned by an active logic signal during a phase in which the supply voltage is lower than the switch-on voltage of the integrated device comprising the LDMOS transistor that emulates a high voltage diode for charging a capacitor.

prising the LDMOS transistor that emulates a high voltage diode for charging a capacitor.

While a normal active clamp placed between the gate node of the integrated transistor and ground should be capable of bearing a voltage twice greater than the supply voltage less a Vbe, the conditioned clamp circuit of the invention may be realized with integrated components which are required to bear a voltage limited to a level similar to that of the supply voltage.

The protecting circuit layout of the invention is specified in claim 1 and consists in using an inverter, substantially referred to the charging node of the bootstrap capacitor control circuit of the LDMOS integrated transistor and to the output node of the controlling inverter, and driven by the logic signal UVLOb which through the output, drives the LDMOS gate node.

The different aspects and advantages of the invention will be even more evident through the following description of a preferred embodiment and by referring to the attached figures, wherein:

Figure 1 shows, as already cited, a driving and control scheme of an LDMOS integrated structure, according to a known technique;

Figure 2 shows the modified protecting a control circuit of the LDMOS gate according to the present invention.

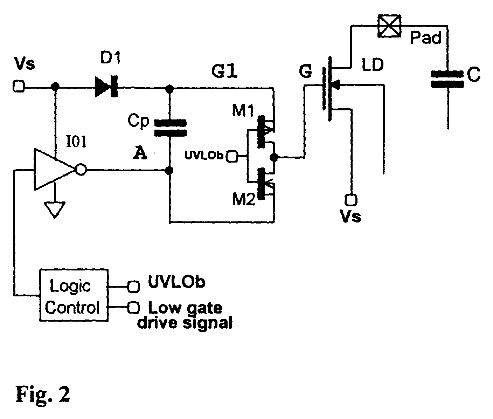

By referring to figure 2, the pMOS M1 has its source connected to the cathode of the diode D1 and to the charging terminal of the bootstrap capacitor Cp, the drain connected to the nMOS M2 drain and to the gate of the LDMOS (LD) integrated transistor. The M2 source is connected to the A output node of the control inverter IO1 and to the other terminal of the bootstrap capacitor Cp.

The M1 and M2 gates are controlled by the logic signal UVLOb, which is 0 when the supply voltage of the Vs device is lower than the minimum switch-on voltage of the integrated device (a condition referred to as "under voltage lock-out") and takes the value of the Vs supply voltage once this threshold is surpassed.

Thence, under normal operating conditions ($UVLOb = Vs$), the low gate drive signal which in the case of driving a half-bridge circuit may reproduce the driving signal of the lower power device, makes the voltage oscillate on the A output node of the inverter IO1 between the ground potential (LDMOS OFF) and the supply potential Vs (LDMOS ON.)

During the phase in which the A node is referred to ground, the Cp capacitance is charged to a voltage equal to Vs less a Vbe (where Vbe is the direct voltage of the D1 diode.) In this condition the transistor M1 has a positive Vgs (=Vbe) and therefore is OFF, while the transistor M2 has a $Vgs=Vs$ and is consequently ON, forcing the voltage of the G gate node to the value of the A node, that is, to ground. Then, in this phase, the gate of the LDMOS transistor (LD) is forced to ground ensuring so a switch-off condition of the transistor.

In the subsequent functioning phase, the logic command on the inverter IO1 goes low and the voltage on the A output node of the inverter reaches the value of the Vs supply voltage. The G1 node reaches a voltage value equal to that of the A node, plus the contribution of the capacitance Cp, in other words equal to 2Vs-Vbe.

Under these conditions, the M1 transistor is ON having a $Vgs=-Vs+Vbe$, and so the voltage on the G gate node, identical to the voltage on the G1 node, is given by 2Vs-Vbe, value that can assure the switch-on of the LDMOS (LD). In this phase the transistor M2 is OFF because Vgs=0.

If a so-called "Under Voltage" condition occurs, that is, when the logic signal UVLOb= 0, given that the gate of the M1 and M2 transistors and the A output node A are at zero, M1 is ON ($Vgs=-Vs+Vbe$) while M2 is OFF (Vgs=0.).

Even in this case, the voltage on the G gate node of the LDMOS transistor is equal to the voltage existing on the G1 node and the LDMOS transistor is ON and therefore the C capacitance may be charged (as it exactly occurs in the known circuit of figure 1.)

Hence, the circuit of the invention consents in operation to force to zero the voltage on the gate node of the LD transistor when it is in a condition of interdiction (while in the known circuit of figure 1 it remained to an uncontrolled value greater or equal to Vs-Vbe), while during a UVLO phase, the circuit preserves a behavior similar to that of the known circuit of figure 1.

**Claims**

1. A circuit for charging a capacitance (C) by means of an LDMOS integrated transistor (LD) functioning as a source follower stage and controlled, in a manner to emulate a high voltage charging diode of the capacitance via a bootstrap (Cp) capacitor charged by a diode (D1) connected to the supply node (Vs) of the circuit, by an (IO1) inverter driven by a logic control circuit in function of a first Low Gate Drive Signal and of a second logic signal (UVLOb) which is active during a phase where the supply voltage (Vs) is lower than the minimum switch-on voltage of the integrated circuit, characterized in that it comprises further

a second inverter (M1, M2), functionally referred to the charging node of said bootstrap (Cp) capacitor and to the voltage of the output node (A) of said inverter (IO1) and having an input coupled to said second logic signal (UVLOb) and an output coupled to the gate node of said LDMOS transistor (LD).

Fig. 1

**Fig. 2**

## EUROPEAN SEARCH REPORT

**European Patent Office**

**Application Number**

EP 97 83 0296

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| D,A | EP 0 743 752 A (SGS THOMSON MICROELECTRONICS)<br>* column 5, line 15 - line 48; figures 5,6 * | 1 | H03K17/06 |
| A | EP 0 545 059 A (DEUTSCHE AEROSPACE)<br>* the whole document * | 1 | |
| A | EP 0 589 123 A (SGS THOMSON MICROELECTRONICS)<br>* the whole document * | 1 | |
| D,A | WO 94 27370 A (PHILIPS ELECTRONICS NV ;PHILIPS NORDEN AB (SE))<br>* abstract; figure * | 1 | |
| A | US 5 365 118 A (WILCOX MILTON E)<br>* abstract * | 1 | |

| | | | TECHNICAL FIELDS SEARCHED (Int.Cl.6) |
|---|---|---|---|
| | | | H03K<br>H02M |

The present search report has been drawn up for all claims

| Place of search | Date of completion of the search | Examiner |
|---|---|---|
| THE HAGUE | 21 November 1997 | Jepsen, J |

EPO FORM 1503 03.82 (P04C01)